# EUROPEAN PATENT APPLICATION

(11) **EP 4 481 491 A1**
(43) Date of publication of application: **25.12.2024**
(21) Application number: 23180448.5
(22) Date of filing: 20.06.2023
(51) Int. Cl.: G03F 7/00, H01L 21/683

(54) **METHOD OF MANUFACTURING AN ELECTRODE FOR AN OBJECT HOLDER**

(71) Applicant: ASML Netherlands B.V., 5500 AH Veldhoven (NL)
(72) Inventor: SCHMIDT, Volker, 5500 AH Veldhoven (NL)
(74) Representative: ASML Netherlands B.V.

(57) **Abstract**

A method of manufacturing an electrode for an object holder, the method comprising forming at least two electrode portions on a first insulating layer, the at least two electrode portions being spaced from each other, forming at least one insulating portion on the first insulating layer between the at least two electrode portions such that the at least one insulating portion fills a space between the at least two electrode portions and the at least two electrode portions form a planar surface with the at least one insulating portion and bonding a second insulating layer to the planar surface.

## Description

### FIELD

The present invention relates to an electrode for an object holder, an object holder and a method of manufacturing the electrode. The object holder may be part of an object table of a lithographic apparatus or lithographic tool.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

The substrate to be exposed may be supported by a substrate holder (i.e. the object that directly supports a substrate), which in turn is supported by a substrate table. Due to the high accelerations that may be experienced by the substrate in use of a high-throughput lithographic apparatus, it may not be sufficient to allow the substrate simply to rest on the substrate holder. It is clamped in place. Two methods of clamping the substrate in place may be used - vacuum clamping and electrostatic clamping. In vacuum clamping, the space between the substrate holder and substrate and optionally between the substrate table and substrate holder are partially evacuated so that the substrate is held in place by the higher pressure of gas or liquid above it. Vacuum clamping, however, may not be used where the beam path and/or the environment near the substrate or substrate holder is kept at a low or very low pressure, e.g. for extreme ultraviolet (EUV) radiation lithography. In this case, it may not be possible to develop a sufficiently large pressure difference across the substrate (or substrate holder) to clamp it. Electrostatic clamping may, therefore, be used. In electrostatic clamping, a potential difference is established between the substrate and the substrate table and/or substrate holder. The potential difference may generate a clamping force. The substrate holder may include an electrode configured to generate the potential difference.

There is a need for an improved electrode that can be used in the substrate holder.

### SUMMARY

According to a first aspect of the invention there is provided a method of manufacturing an electrode for an object holder, the method comprising forming at least two electrode portions on a first insulating layer, the at least two electrode portions being spaced from each other, forming at least one insulating portion on the first insulating layer between the at least two electrode portions such that the at least one insulating portion fills a space between the at least two electrode portions and the at least two electrode portions form a planar surface with the at least one insulating portion and bonding a second insulating layer to the planar surface.

The method may allow for manufacturing of an improved electrode for the object holder. For example, by forming the at least one insulating portion on the first insulating layer between the at least two electrode portions such that the at least one insulating portion fills a space between the at least two electrode portions and the at least two electrode portions form the planar surface with the insulating portions, a distance between the at least two electrode portions may be reduced, e.g. while the at least one insulating portion provides an electrical insulation between the at least two electrode portions. The decreased distance between the at least two electrode portions may allow for a number of electrode portions on the first insulating layer to be increased. This in turn may result in an increased yield of the electrode. The formation of the at least one insulating portion between the at least two electrode portions such that the at least one insulating portion fills a space between the at least two electrode portions may result in an increased breakthrough voltage of the electrode. The formation of the at least one insulating portion on the first insulating layer between the at least two electrode portions such that the at least two electrode portions and the at least two electrode portions form the planar surface may allow for an improved bond of the second insulating layer to the at least two electrode portions and the at least one insulating portion.

The at least two electrode portions and the at least one insulating portion may have the same height, e.g. substantially the same height. This may allow for an improved bond of the second insulating layer to the at least two electrode portions and the at least one insulating portion.

The at least two electrode portions and the at least one insulating portion may be formed on: at least one side of the first insulating layer or on each of at least two opposite sides of the first insulating layer. For example, when the at least two electrode portions and the at least one insulating portion are formed on each of the at least two opposite sides of the first insulating layer, the method may comprise bonding a second insulating layer to the planar surface formed on each of the at least two opposite sides of the first insulating layer.

The method may comprise forming at least two electrode portions on each of a plurality of first insulating layers. The method may comprise forming at least one insulating portion on each of the plurality of the first insulating layers, e.g. between the at least two electrode portions such that the at least one insulating portion fills a space between the at least two electrode portions and the at least two electrode portions form a planar surface with the at least one insulating portion. The method may comprise bonding the plurality of first insulating layers and/or the second insulating layer together, e.g. such that the at least two electrode portions and the at least insulating portion on each of the plurality of first insulating layer are arranged: between the second insulating layer and a respective first insulating layer of the plurality of first insulating layers or between the respective first insulating layer of the plurality of first insulating layers and at least one other of the plurality of first insulating layers.

The at least two electrode portions and the at least one insulating portion may be formed on: at least one side of at least one or each of the plurality of first insulating layers and/or each of at least two opposite sides of at least one of the plurality of first insulating layers.

The method may comprise bonding the second insulating layer to the planar surface and/or bonding the plurality of first insulating layers and/or the second insulating layer together, e.g. using at least one of: a diffusion bonding process, an anodic bonding process, a Spark plasma assisted hot press process and/or an optical contact bonding process.

Forming the at least one insulating portion on the first insulating layer and/or on each of the plurality of first insulating layers may comprise depositing a layer of insulating material on the at least two electrode portions and the first insulating layer and/or each of the plurality of first insulating layers. Forming the at least one insulating portion on the first insulating layer and/or each of the plurality of first insulating layers may comprise removing a portion of the layer of insulating material, e.g. such that the at least two electrode portions form the planar surface with at least one remaining portion of the layer of insulating material. The at least one remaining portion may form or comprise the at least one insulating portion.

The first insulating layer, the second insulating layer and/or at least one or each of the plurality of first insulating layers may comprise a ceramic material or glass material. The ceramic material or glass material of at least one of: the first insulating layer, at least one or each of the plurality of first insulating layers and/or the second insulating layer may be the same as or different from the ceramic material or glass material of at least one other of: the first insulating layer, the at least one or each of the plurality of first insulating layers and/or the second insulating layer. By providing a first insulating layer, at least one or each of the plurality of first insulating layers and/or a second insulating layer comprising a ceramic material, a robustness and/or fracture toughness of the electrode may be improved. The ceramic material may comprise an opaque or a non-transparent ceramic material.

The at least two electrode portions may comprise an electrically conductive material. The at least one insulating portion may comprise an insulating material. A hardness of the insulating material may be less than a hardness of the electrically conductive material. The use of the insulating material having a hardness less than a hardness of the electrically conducting material may allow for the insulating portion being formed with the same height as the at least two electrode portions, e.g. using a polishing or planarization process. Additionally or alternatively, this may facilitate the formation of the planar surface.

The electrically conductive material comprises at least one of: a conductive ceramic material, a semiconductor material and/or doped diamond. The insulating material comprises at least one of: a quartz material, a glass material and/or a ceramic material.

The first insulating layer, at least one of the plurality of first insulating layers and/or the second insulating layer may comprise one or more electrically conductive portions. The one or more electrically conductive portions may be configured and/or arranged to electrically connect one or more respective electrode portions of the at least two electrode portions, e.g. arranged or formed on each of the at least two opposite sides of the first insulating layer and/or the at least one of the plurality of first insulating layers with each other. The one or more electrically conductive portions may be configured and/or arranged to electrically connect one or more electrode portions of the at least two electrodes portion formed on the first insulating layer and/or the at least one of the plurality of first insulating layers with another part or component of the object holder.

According to a second aspect of the invention there is provided an electrode for an object holder comprising at least two electrode portions arranged or formed on a first insulating layer, the at least two electrode portions being spaced from each other and at least one insulating portion arranged or formed on the first insulating layer between the at least two electrode portions such that the at least one insulating portion fills a space between the at least two electrode portions and the at least two electrode portions form a planar surface with the at least one insulating portion and a second insulating layer bonded to the planar surface.

The at least two electrode portions and the at least one insulating portion may be arranged or formed on at least one side of the first insulating layer or on each of at least two opposite sides of the first insulating layer. For example, when the at least two electrode portions and the at least one insulating portion are arranged or formed on each of the at least two opposite sides of the first insulating later, a second insulating layer may be bonded to the planar surface formed on each of the at least two opposite sides of the first insulating layer.

The electrode may comprise a plurality of first insulating layers. The at least two electrode portions may be formed or arranged on each of the plurality of first insulating layers. The electrode may comprise at least one insulating portion arranged or formed on each of the plurality of the first insulating layers between the at least two electrode portions, e.g. such that the at least one insulating portion fills a space between the at least two electrode portions and the at least two electrode portions form a planar surface with the at least one insulating portion. The plurality of first insulating layers and/or the second insulating layer may be bonded together, e.g. such that the at least two electrode portions and the at least one insulating portion on each of the plurality of first insulating layers are arranged between the second layer and a respective first insulating layer of the plurality of first insulating layers. The plurality of first insulating layers and/or the second insulating layer may be bonded together, e.g. such that the at least two electrode portions and the at least one insulating portion on each of the plurality of first insulating layers are arranged between the respective first insulating layer of the plurality of first insulating layers and at least one other of the plurality of first insulating layers.

The electrode may comprise one or more electrically conductive portions, such as one or more vias. The one or more electrically conductive portions may be part of or comprised in the first insulating layer, at least one of the plurality of first insulating layers and/or the second insulating layer. The one or more electrically conductive portions may be configured and/or arranged to electrically connect one or more respective electrode portions of the at least two electrode portions arranged or formed on each of the at least two opposite sides of the first insulating layer and/or the at least one of the plurality of first insulating layers with each other. The one or more electrically conductive portions may be configured and/or arranged to electrically connect one or more electrode portions of the at least two electrodes portion formed or arranged on the first insulating layer and/or the at least one of the plurality of first insulating layers with another part or component of the object holder.

The electrode may be manufactured using the method of the first aspect.

According to a third aspect of the invention there is provided an object holder configured to support an object comprising an electrode according to second aspect.

According to a fourth aspect of the invention there is provided an object table comprising an object holder according to the third aspect.

According to a fifth aspect of the invention there is provided lithographic apparatus comprising an illumination system, a projection system and an object table according to fourth aspect.

According to a sixth aspect of the invention there is provided a lithographic tool comprising an object table according to the fourth aspect.

Various aspects and features of the invention set out above or below may be combined with various other aspects and features of the invention as will be readily apparent to the skilled person.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 schematically depicts in cross section a part of an exemplary electrode for an object holder for use in the lithographic apparatus of Figure 1;
- Figure 3 depicts a plan view of the electrode of Figure 2;
- Figure 4 schematically depicts in cross section a part of another exemplary electrode for an object holder for use in the lithographic apparatus of Figure 1;
- Figure 5 schematically depicts in cross section a part of an exemplary object holder for use in the lithographic apparatus of Figure 1;
- Figure 6 depicts a flow chart illustrating in overview a method of manufacturing an electrode for an object holder; and
- Figure 7 depicts a flow chart illustrating in overview one or more steps that may be part of the method of Figure 6.

### DETAILED DESCRIPTION

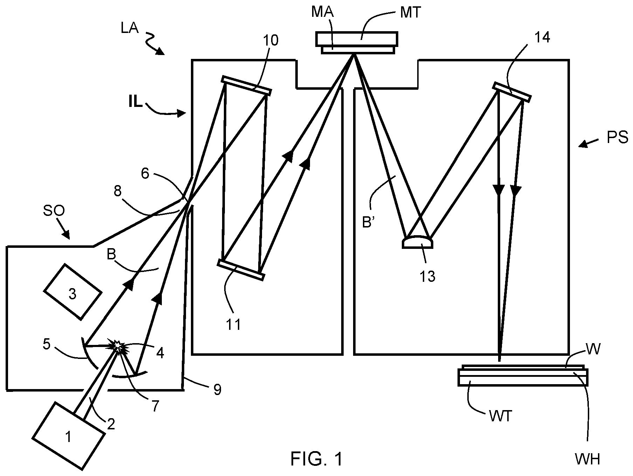

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and an object table WT. The object table WT may comprise an object holder WH configured to support an object W. The object W may be provided in the form of a substrate. The object table WT may be provided in the form of a substrate table. The object holder WH may be provided in the form of a substrate clamp.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Figure 1 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure, which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 1 depicts the radiation source SO as a laser produced plasma (LPP) source, any suitable source such as a discharge produced plasma (DPP) source or a free electron laser (FEL) may be used to generate EUV radiation.

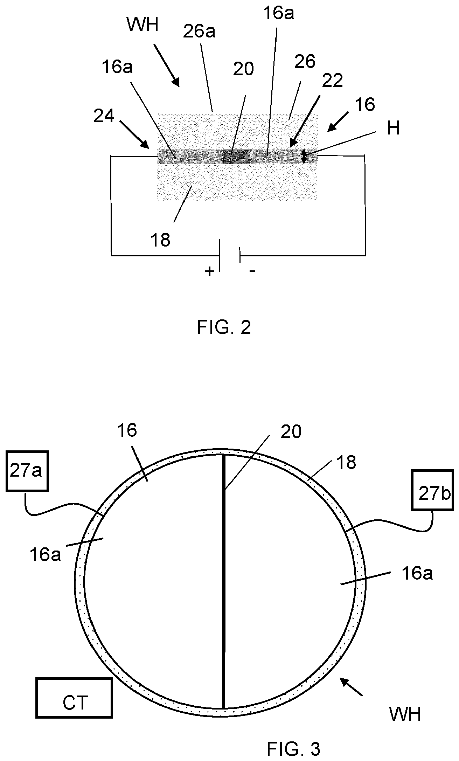

Figure 2 schematically shows in cross section a part of an exemplary electrode 16 for an object holder WH for use in the lithographic apparatus LA shown in Figure 1. In the embodiment shown in Figure 2, the electrode 16 may be configured to act as an object holder WH. The electrode 16 comprises two electrode portions 16a arranged on a first insulating layer 18. The electrode 16 may also be referred to as a structured electrode. In this embodiment, the object holder WH is provided in the form of an electrostatic clamp, such as a bipolar electrostatic clamp. Although Figure 2 shows two electrode portions 16a, it will be appreciated that in other embodiments, the electrode may comprise more than two electrode portions. For example, in other embodiments, the electrode may comprise tens, hundreds or thousands of electrode portions.

The electrode 16 comprises an insulating portion 20. The insulating portion 20 is arranged or formed between the electrode portions 16a. The insulating portion 20 is arranged or formed to fill a space between the electrode portions 16a. The insulating portion 20 may be arranged between the electrode portions 16a to electrically isolate the electrode portions 16a from each other. This may allow for voltages applied to the electrode 16, e.g. the two electrode portions 16a, to be independently and/or separately controlled. For example, voltages of opposite pluralities may be applied to the electrode portions 16a. In use, when a voltage is applied to the electrode 16, e.g. the electrode portions 16a, a potential difference between the object holder WH and the object W is generated. This will give rise to the electrostatic clamping effect, thereby clamping the object W to the object holder WH, e.g. the object table WT. The voltage applied to the electrode 16, e.g. the electrode portions 16a, may be in the region of about 1kV to 8kV, e.g. to generate a sufficient clamping force. By forming or arranging the insulating portion 20 between the electrode portions 16a such that the insulating portion 20 fills the space between the electrode portions 16a, a distance between the electrode portions 16a may be reduced while the insulating portion provides 20 an electrical insulation between the electrode portions 16a, as will be described below in more detail. The decreased distance between the electrode portions 16a may allow for a number of electrode portions on the first insulating layer 18 to be increased. This in turn may result in an increased yield of the electrode 16. Additionally or alternatively, the arrangement or formation of the insulating portion 20 between electrode portions 16a, e.g. such that the insulating portion fills the space between the adjacent electrode portions, may result in an increased breakthrough voltage of the electrode 16. The insulating portion 20 and the electrode portions 16a may form an electrode layer 24.

The insulating portion 20 is arranged or formed between the electrode portions 16a, e.g. such that the electrode portions 16a form a planar surface 22 with the electrode portions 16a. For example, the electrode portions 16a and the insulating portion 20 may be arranged or formed to form the planar surface 22. For example, the electrode portions 16a and the insulating portions 20 may comprise the same height H. Although a single insulating portion 20 is shown in Figure 2, it will be appreciated that in other embodiments, the electrode may comprise more than one insulating portion. Additionally, the electrode 16 may comprise at least one other insulating portion arranged to electrically isolate the electrode portions 16a to an exterior of the electrode 16.

The electrode 16 comprises a second insulating layer 26 bonded to the planar surface 22. Expressed differently, the second insulating layer 26 is bonded to the electrode portions 16a and the insulating portion 20. By arranging or forming the electrode portions 16a and the insulating portion 20 with the same height H and/or to form the planar surface 22, a bond or connection of the second insulating layer 26 to the electrode portions 16a and the insulating portion 20 may be improved. The electrode 16 may be provided in the form of an embedded electrode. In this embodiment, the second insulating layer 26 may comprise or define an object receiving surface 26a.

Figure 3 shows a plan view of the electrode 16 shown in Figure 2. The second insulating layer has been omitted from Figure 3 for clarity purposes. The object holder WH may have a circular shape. A diameter of the object holder WH may be in the region of about 340 mm to 400 mm, such as 350 mm. It will be appreciated that the dimensions of the object holder disclosed herein are merely exemplary dimensions and that in other embodiments other dimensions of the object holder may be used.

In the embodiment shown in Figure 3, the first insulating layer 18 has a diameter that is larger than the electrode 16. This may allow another insulating portion (not shown) to be arranged to surround at least a part of a periphery of the electrode 16, e.g. to electrically isolate to the electrode portions 16a to an exterior of the electrode 16.

As described above, in this embodiment, the electrode 16 comprises two electrode portions 16a. Each of the two electrode portions 16a may be generally semi-circular. A first voltage source 27a may be connected to one of the two electrode portions 16a. The first voltage source 27a may be configured to apply a voltage to one of the two electrode portions 16a. A second voltage source 27b may be connected to the other one of the two electrode portions 16a. The second voltage source 27b may be configured to apply a voltage to the other of the two electrode portions 16a. The first and second voltage sources 27a, 27b may be configured to apply voltages of opposite pluralities to the two electrode portions 16athe. The two electrode portions 16a may be arranged to be adjacent to each other. However, as described above, the two electrode portions 16a are electrically isolated from each other by the insulating portion 20. The first and/or second voltage sources 27a, 27b may be controlled by a controller CT. It will be appreciated that the arrangement and/or shape of the electrode portions disclosed herein are merely exemplary dimensions and that in other embodiments, the electrode portions may be differently shaped and/or arranged.

The electrode 16 described herein is not limited to being implemented as described above in relation to Figures 2 and 3 and may be implemented differently in an object holder. For example, in other embodiments, the electrode may be part of a modular object holder. In other embodiments, the electrode may be implemented as an electrostatic sheet of the modular object holder, such as the object holder described in WO 2021/185552 or WO 2021/240074 both of which are hereby incorporated in their entirety by reference.

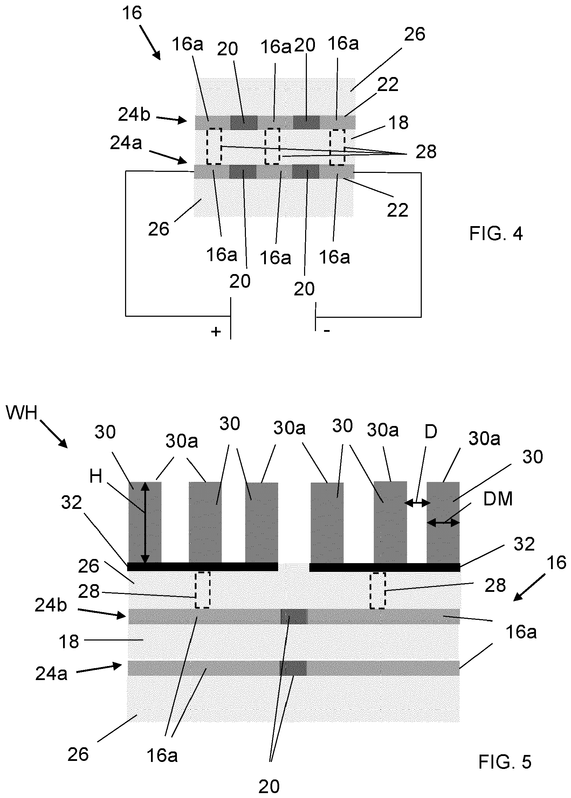

Figure 4 schematically shows in cross section a part of another exemplary electrode 16 for an object holder for use in the lithographic apparatus LA shown in Figure 1. The electrode 16 in Figure 4 is similar to the electrode shown in Figures 2 and 3. As such, any features described in relation to the electrode shown in Figure 2 and 3 may also apply to the electrode shown in Figure 4. Only differences will be described in the following.

In the embodiment shown in Figure 4, the electrode 16 comprises three electrode portions 16a and two insulating portions 20. Each insulating portion 20 is arranged between two adjacent electrode portions 16a. In this embodiment, the electrode portions 16a and two insulating portions 20 are arranged on each of the opposite sides of the first insulating layer 18. The electrode portions 16a and the insulating portions 20 are arranged to form electrode layers 24a, 24b on each of the opposite sides of the first insulating layer 18. As described above, the electrode portions 16a and the insulating portions 20 form a planar surface on each of the opposite sides of the first insulating layer 18. In this embodiment, a second insulating layer 26 is bonded to the planar surface 22 on each of the opposite sides of the first insulating layer 18. However, it will be appreciated that in other embodiments a further first insulating layer may be bonded to the planar surface on at least one of the opposite sides of the first insulating layer 18.

The electrode 16 may comprise one or more electrically conductive portions. In this embodiment, the electrically conductive portions are part of the first insulating layer 18. However, it will be appreciated that in other embodiments, the electrically conductive portions may be part of the second insulating layer. The electrically conductive portions may be implemented as vias 28. The vias 28 may be arranged to electrically connect one or more respective electrode portions 16a formed or arranged on each of the opposite sides of the first insulating layer 18 with each other, as shown in Figure 4. In such embodiments, the first insulating layer 18 may be referred to as an interposer layer. It will be appreciated that in other embodiments, the vias may be arranged to electrically connect respective electrode portions formed on one first insulating layer with electrode portions formed on another first insulating layer. Alternatively or additionally, the vias may be arranged to connect one or more electrode portions to another part or component, such as a sensor, heating element, other electrode portion or the like, of the object holder.

The electrode 16 shown in Figure 4 may be considered as defining a stacked arrangement of electrode portions 16a and insulating portions 20. In this embodiment, the electrode 16 comprises two electrode layers 24a, 24b. The electrode layers 24a, 24b are arranged or stacked above each other. Although in the embodiment shown in Figure 4, the electrode comprises two electrode layers 24a, 24b, it will be appreciated that in other embodiments, the electrode may comprise more or less than two electrode layers.

By configuring the electrode 16 to comprise a stacked arrangement of electrode portions 16a and insulating portions 20, the electrode 16 may be used in an active or adaptive object holder. For example, a voltage may be applied to two or more of the electrode portions 16a of a first electrode layer 24a. The first electrode layer 24 may be arranged below the first insulating layer 18 and/or distal to an object receiving surface (not shown in Figure 4) of the object holder. For the sake of clarity, Figure 4 shows the voltage as being applied to two outer electrode portions 16a. However, it will be appreciated that the voltage may be applied to each of the electrode portions 16a. The electrode portions 16a of the first electrode layer 24a may be electrically connected with the electrode portions 16a of a second electrode layer 24 via the vias 28. The second electrode layer 24b may be formed above the first insulating layer 18 and/or proximal to the object receiving surface of the object holder. The electrode portion 16a of the second electrode layer 24b may be configured to generate the clamping force. The voltage applied to the first electrode layer 24a, e.g. two or more of the electrode portions 16a thereof, may be applied via the vias 28 to the second electrode layer 24b, e.g. two or more of electrode portions 16a thereof. In some embodiments, different voltages may be applied to two or more electrode portions 16a of the second electrode layer 24b, e.g. via the electrode portions 16a of the first electrode layer 24a. The different voltages may be selected so as to keep the object W generally flat on the object holder WH and/or to avoid deformation of the object W and/or the object holder WH. For example, lithographic exposure of the object W may result in heat being generated in the object W. The generated heat may cause the object W to expand locally and/or deform.

Figure 5 schematically shows in cross section a part of an exemplary object holder WH for use in the lithographic apparatus LA shown in Figure 1. The object holder WH comprises an electrode 16. The electrode shown in Figure 5 is similar to the electrode shown in Figure 4. As such, any features described in relation to the electrode shown in Figure 4 may also apply to the electrode shown in Figure 5. Only differences will be described in the following. The object holder WH shown in Figure 5 may be considered as another exemplary adaptive or active object holder. In this embodiment, each of the first and second electrode layers 24a, 24b comprises two electrode portions 16a and an insulating portion 20. The insulating portion 20 is arranged between the two electrode portions 16a.

In this embodiment, the object holder WH comprises a plurality of burls 30. The burls 30 may be arranged to extend or protrude from the electrode 16, e.g. the second insulating layer 24. However, it will be appreciated that in other embodiments, the burls may extend or project from another layer or part of the object holder. Each of the burls comprises an object receiving surface 30a.

In the embodiment shown in Figure 5, the burls extend or project upwardly from the electrode 16. However, it will be appreciated that in other embodiments, the burls may additionally or alternatively extend or project downwardly from the electrode and/or another layer or part of the object holder. The burls 30 may define or be arranged in an array of burls. The burls 30 may have a cylindrical or truncated cone shape. A diameter DM of each burl 30 may be in the range of about 150 µm to 1000 µm. A height H of each burl 30 may be in the region of about 100 µm to 3000 µm. A distance D between at least two neighbouring burls 30 may be in the region of about 2 mm to 3 mm. It will be appreciated that the dimensions of the burls disclosed herein are merely exemplary dimensions and that in other embodiments, the burls may have other dimensions.

A voltage may be applied to the electrode portions 16a of the first electrode layer 24a, e.g. to generate the clamping force. In use, clamping of the object W to the object receiving surface 30a of each burl 30 may cause compression of one or more of the burls 30. As such, it may be desirable to vary a size or dimension, such as at least a height, of the burls 30, e.g. to compensate for the compression of the burls and/or to keep the object W generally flat. The size or dimension of the burls 30 may varied by, e.g. heating the burls 30. For example, by heating the burls 30, the burls may expand and/or a height of the burls 30 may increase. In such embodiments, the object holder WH may comprise a plurality of heating elements 32. The heating elements 32 may be arranged to heat the one or more burls 30. In the example shown in Figure 5, a heating element 32 may be arranged to heat three burls. However, it will be appreciated that in other embodiments, the heating element may be arranged to heat more or less than three burls. The burls 30 may comprise a semiconductor material, such as silicon carbide or the like, a ceramic material, such as an insulating ceramic material, a glass material or the like. The ceramic material may comprise aluminium oxide or the like. The glass material may comprise quartz glass material, such as silica or fused silica or the like. It will be appreciated that burls described herein are not limited to comprising the exemplary materials disclosed herein and that in other embodiments the burls may comprise another material.

A voltage may be applied to the electrode portions 16a of the second electrode layer 24b. The second insulating layer 26 may comprise vias 28, e.g. to electrically connect at least one electrode portion 16a of the second electrode layer 24b to at least one heating element 32. It will be appreciated that in other embodiments, the vias may be differently arranged. The electrode portions 16a of the second electrode layer 24b may be used to control the one or more burls 30 of the object holder WH. In the example, shown in Figure 5, each electrode portion 16a of the second electrode layer 24b is associated with and/or arranged to control three burls 30. It will be appreciated that in other embodiments, an electrode portion may be associated with and/or arranged to control more or less than three burls.

Alternatively, the burls may comprise a piezoelectric material, such as nanosized silicon nitride, lead zirconium titanate (PZT or Pb(Zr,Ti)O₃), lead magnesium niobate-lead titanate (PMN-PT or Pb(Mg_{1/3}Nb_{2/3})O₃-PbTiO₃), barium titanate (BTO or BaTiO₃), barium strontium titanate (BST or Ba_{0.5}Sr_{0.5}TiO₃), potassium-sodium niobate (KNN or K_{0.5}Na_{0.5}NbO₃), potassium sodium bismuth titanate (KNBT or (K,Na)_{0.5}Bi_{0.5}TiO₃), bismuth ferrite (BFO or BiFeO₃) or the like. The size or dimension of one or more burls may then be varied by applying a voltage to the one or more burls, e.g. via the electrode portions of the second electrode layer, as described above. In such embodiments, the heating elements shown in Figure 5 may be replaced by an electrode or electrical contact. The electrode or electrical contact may be configured to apply the voltage to the burls, e.g. via the electrode portions of the second electrode layer.

It will be appreciated that in other embodiments, the electrode may be differently used and/or implemented. For example, in other embodiments, a voltage may be applied to an electrode layer or at least two electrode portions, e.g. to generate the electrostatic clamping force and another voltage may be applied to another electrode layer or at least two other electrode portions, e.g. to apply a voltage to another component of the object holder, such as a sensor or the like, via one or more vias.

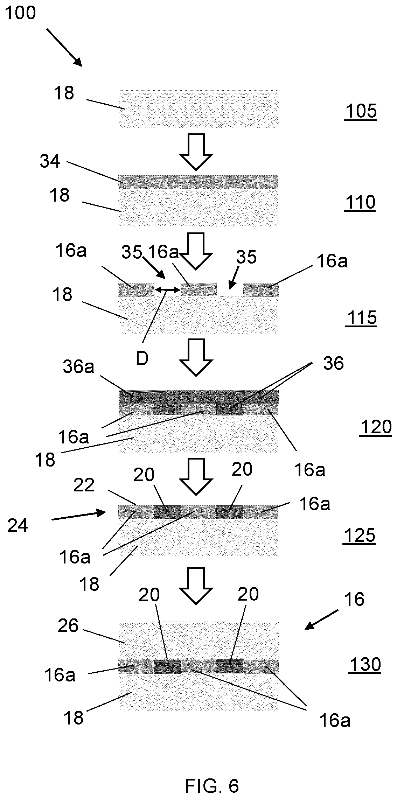

Figure 6 shows a flow chart illustrating in overview a method 100 of manufacturing an electrode for an object holder, such as the object holder WH. The electrodes 16 shown in any one of Figures 2 to 5 may each be manufactured using the method 100.

In step 105, the method 100 may comprise forming or providing a first insulating layer 18. The first insulating layer 18 may comprise a ceramic material or a glass material. The ceramic material of the first insulating layer 18 may comprise silicon nitride, aluminium oxide, aluminium nitride and/or the like. The glass material may comprise borosilicate glass or the like.

The method 100 may comprise providing a first material for forming the first insulating layer 18. The first material may be provided in the form of a ceramic suspension. It will be appreciated that in other embodiments, the first material may be provided in the form of a powder or the like. The ceramic suspension of the first material may also be referred to as a green state ceramic. The first material may be soft and/or deformable to facilitate shaping of the first material, for example into a selected or desired shape and/or to allow for printing of the first material. The method 100 may comprise using a sintering and/or hot press process to form the first insulating layer. The sintering and/or hot press process may comprise heating the first and material at a temperature between about 1500° C to 1700° C. It will be appreciated that in other embodiments, the first insulating layer may be formed using a deposition process, such as chemical vapour deposition.

A thickness of the first insulating layer 18 may be between about 1 mm and 20 mm. The first insulating layer 18 may comprise a volume resistance in the region of 10¹⁶ Ohm cm to 10¹⁸ Ohm cm.

In steps 110 and 115, the method 100 comprises forming at least two electrode portions 16a on the first insulating layer 18. For example in step 110, the method may comprise depositing a layer of conductive material 34 on the first insulating layer 18, e.g. using a deposition process, such as a vacuum deposition process or a physical vapour deposition process. The layer of conductive material 34 may comprise an electrically conductive material. The electrically conductive material may comprise a hardness larger than 9 GPa Vickers Hardness. For example, the hardness of the electrically conductive material may be in the range of about 10 GPa to 20 GPa, such as about 15 GPa. The electrically conductive material may comprise a conductive ceramic material, such as titanium nitride or the like, and/or a semiconductor material, such as silicon carbide or the like. The electrically conductive material may comprise a volume resistance of less than 1 Ω·cm, preferably less than 0.1 Ω·cm or less than or equal to 1 µΩ·cm.

In examples where the electrically conducting material comprises titanium nitride, the electrically conducting material may comprise an excess of titanium relative to stoichiometric titanium nitride. For example, the electrically conducting material may comprise a titanium nitride composition of 10% more titanium than stoichiometric titanium nitride. This may facilitating bonding of the second insulating layer to the electrode portions 16a, as will be described below.

In some embodiments, the electrically conductive material may comprise doped diamond, such as diamond doped with boron. An exemplary volume concentration of boron in diamond may be between about 100 ppm (0.01%) and 8000 ppm (0.8%). In such embodiments, the electrically conducting material may comprise a volume resistance between about 5 × 10⁻³ Ohm·cm and 200 × 10⁻³ Ohm.cm, such as about 25 × 10⁻³ Ohm·cm.

For example in step 115, the method 100 may comprise removing one or more portions of the layer of conductive material 34 to form the electrode portions 16a. Step 115 may comprise using a material removal process, e.g. to remove the portions of the layer of conductive material 34. The material removal process may comprise a lithographic process, such as a photolithographic process or the like. For example, a layer of photoresist (not shown in Figure 6) may be deposited on the layer of conductive material 34. The layer of photoresist may be masked, exposed and/or developed to form a pattern of the electrode portions 16a in the layer of photoresist. The method 100 may comprise an etching process to remove one or more portions of the conductive layer 34 that are not protected by the layer of photoresist, e.g. to form the pattern of electrode portions 16a. In the embodiment shown in Figure 6, three electrode portions 16a are formed. A space or gap 35 may be formed between adjacent electrode portions 16a. It will be appreciated that in other embodiment, more or less than three electrode portions may be formed.

It will be appreciated that the method disclosed herein is not limited to using a lithographic process for removing the one or more portions of the layer of conductive material. For example, in other embodiments, one or more other material removal processes may be used, such as laser ablation or the like.

Each electrode portion 16a may comprise a thickness between about 5 nm and about 100 µm.

In steps 120 and 125, the method 100 comprises forming at least one insulating portion 20 on the first insulating layer 18. The insulating portion 20 is formed between adjacent electrode portions 16a such that the electrode portions 16a form a planar surface 22 with the insulating portion 20. For example, in step 120, the method 100 comprises depositing a layer of insulating material 36 on the electrode portions 16a and the first insulating layer 18. The layer of insulating material 36 may be deposited on the electrode portions 16a and the first insulating layer 18 using a deposition process, such as physical vapour deposition or other deposition process. The layer of insulating material 36 may be deposited such that the spaces or gaps 35 between adjacent electrode portions 16a are filled with the insulating material. The insulating material may comprise a hardness that is less than a hardness of the electrically conductive material of the electrode portions 16a. For example, the insulating material may comprise a hardness equal to or less than 9GPa Vickers hardness. The insulating material may comprise a quartz material, such as silicon dioxide, fused silica or the like, a glass material, such as borosilicate glass, a ceramic material, such as aluminium oxide, and/or another insulating material.

In step 125, the method 100 comprises removing a portion of the layer of insulating material 36. The portion of the layer of insulating material 36 that is removed in this step is indicated in step 120 shown in Figure 6 by reference numeral 36a. The portion 36a of the layer of insulating material 36 may be removed such that the electrode portions 16a form the planar surface 22 with one or more remaining portions of the layer of insulating material 36. Each of the one or more remaining portions of the layer of insulating material 36 may form an insulating portion 20. The insulating portion 20 fills the spaces or gaps 35 between the adjacent electrode portions 16a. The portion 36a of the layer of insulating layer 36 may be removed such that the electrode portions 16a are exposed. In other words, no insulating material of the layer of insulating material 36 may be present on the electrode portions 16a. The method 100 may comprise using a polishing or planarization process to remove the portion 36a of the layer of insulating material 36. The use of the insulating material having a hardness less than a hardness of the electrically conducting material may allow for the insulating portion 20 being formed with the same height as the electrode portions 16a. This may facilitate the formation of the planar surface 22.

In step 130, the method comprises bonding a second insulating layer 26 to the planar surface 22. For example, the second insulating layer 26 is bonded to the electrode portions 16a and the insulating portions 20. In this embodiment, the second insulating layer 26 is bonded to the planar surface 22 using a diffusion bonding process. A pressing pressure and/or temperature may be selected based on a material of the second insulating layer 26, the insulating material of the insulating portions 20 and/or the conductive material of the electrode portions 16a. For example, the temperature during bonding of the second insulating layer 26 to the planar surface 22 may be in the range of about 240°C to 2000°C, preferably in a range of about 500°C to 1500°C, such as about 900°C. The pressing pressure may be in a range of about 5×10⁶ Pa (50 bar) to 2×10⁸ Pa (2000 bar), preferably in a range of about 1.5×10⁷ Pa (150 bar) to 5×10⁷ Pa (500 bar). It will be appreciated that in other embodiments, the second insulating layer may be bonded to the planar surface using a different bonding process, such as an anodic bonding process, an optical contact bonding process, a Spark plasma assisted hot press process and/or the like.

The second insulating layer 26 may comprise a ceramic material or a glass material. The ceramic material or glass material of the second insulating layer 26 may be the same as the ceramic material or glass material of the first insulating layer 18. Alternatively, the ceramic material or glass material of the second insulating layer 26 may be different from the ceramic material or the glass material of the first insulating layer 18. In examples, where the ceramic material or glass material of the second insulating layer 26 is different from the ceramic material of glass material of the first insulating layer 18, the ceramic material or glass material of the second insulating layer 26 may comprise a coefficient of thermal expansion that is the same or similar to a coefficient of thermal expansion of the ceramic material or glass material of the first insulating layer 18. The ceramic material of the second insulating layer 26 may comprise at least one of silicon nitride, aluminium oxide and/or aluminium nitride. The glass material of the second insulating layer 26 may comprise borosilicate glass or the like. The second insulating layer 26 may be formed in the same manner as the first insulating layer 18. A thickness of the second insulating layer 26 may be between about 1 mm and 20 mm. The second insulating layer 26 may comprise a volume resistance in the region about 10¹⁶ Ohm cm to 10¹⁸ Ohm cm.

The method 100 may allow for manufacturing of an improved electrode for the object holder WH. For example, by forming the insulating portion 20 between adjacent electrode portions 16a such that the insulating portion 20 fills the space 35 between adjacent electrode portions 16a and the electrode portions 16a form a planar surface with the insulating portions 20, as described above, a distance between the electrode portions 16a may be reduced while the insulating portion 20 provides an electrical insulation between the electrode portions. For example, a distance D between at least two adjacent electrode portions 16a may be equal to or larger than about 0.1 mm. A minimum value of the distance D between the adjacent electrode portions may depend on a breakthrough voltage of the insulating material of the insulating portion 20. The decreased distance D between adjacent electrode portions may allow for a number of electrode portions on the first insulating layer 18 to be increased. This in turn may result in an increased yield of the electrode 16. The formation of the insulating portion 20 between adjacent electrode portions 16a, e.g. such that the insulating portion 20 fills the space 35 between adjacent electrode portions 16a, may result in an increased breakthrough voltage of the electrode 16. It will be appreciated that the distance D between the at least two adjacent electrode portions 16a corresponds to a width of the insulating portion 20.

The method 100 described herein may allow for the use of a ceramic material, such as a non-transparent ceramic material, for the first and second insulating layers. As such, the electrode 16 may be more robust relative to an electrode comprising a glass material. For example, a fracture toughness of glass is 0.8 MPa/mm² while a fracture toughness of, e.g. silicon nitride is about 6 MPa/mm².

The electrode portions 16a and the insulating portion 20 may be formed on at least one side of the insulating layer 18 or on each of at least two opposite sides of the insulating layer 18. When the electrode portions 16a and the insulating portion 20 are formed on each of the opposite sides of the first insulating layer 18, the method comprises bonding a second insulating layer 26 to the planar surface 22 on each of the opposite sides of the first insulating layer 18. As such, electrode portions 16a and insulating portions 20 may be formed between the first layer 18 and a second insulating layer 26 and between the first layer 18 and another second layer 26, as shown in Figures 4 and 5.

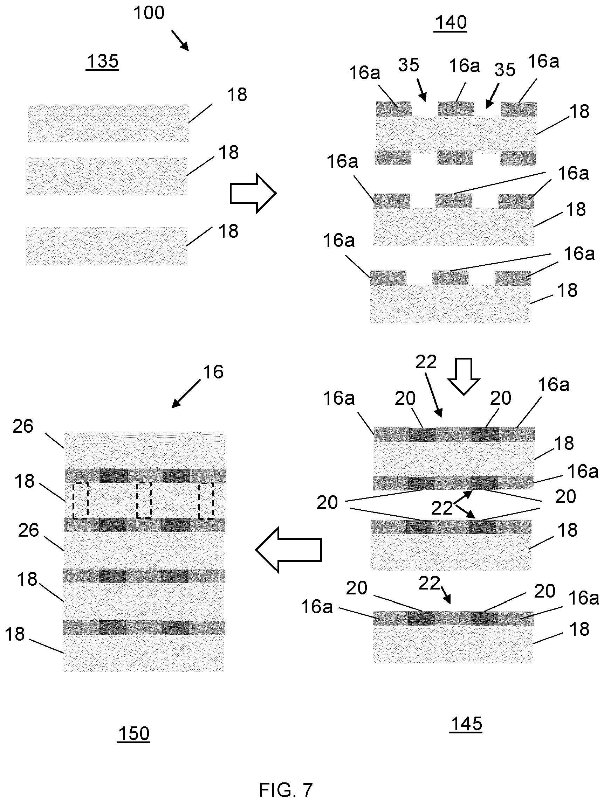

Figure 7 shows a flow chart illustrating in overview one or more steps that may be part of the method 100 shown in Figure 6.

In step 135, the method 100 may comprise providing or forming a plurality of first insulating layer 18, two of which are shown in Figure 7. The insulating layer 18 shown in Figure 6 may be a part of the plurality of first insulating layers 18.

In step 140, the method 100 may comprise forming at least two electrode portions 16a on each of the first insulating layers 18. The electrode portions 16a may be formed on at least one side of one or more of the first insulating layers 18 or on each of the two opposite sides of one or more other of the first insulating layers 18. In the example shown in Figure 7, the electrode portions 16a are formed on at least one side of two of the first insulating layers 18 and on each of the two opposite sides of another first insulating layer 18. The electrode portions 16a may be formed as described above in steps 110 and 115 of the method 100.

In step 145, the method 100 may comprise forming insulating portions 20 on each of the first insulating layers 18 between adjacent electrode portions 16a such that insulating portions 20 fills the space 35 between two adjacent electrode portions 16 and the electrode portions 16a form a planar surface 22 with the insulating portions 20. The insulating portions may be formed as described above in steps 120 and 125 of the method 100.

In step 150, the method comprises bonding the first insulating layers 18 and at least one second insulating layer 26 together. In the example shown in Figure 7, two second insulating layers 26 are provided or formed. The first insulating layers 18 and the second insulating layer 26 may be bonded together such that the electrode portions 16a and the insulating portions 20 on each of the first insulating layers 18 is arranged between the second layer 26 and the respective first insulating layer 18 or between the respective first insulating layer 18 and another first insulating layer 18. In examples, where the electrode portions 16a and insulating portions 20 are formed only one the side of each first insulating layer 18, the first insulating layers 18 and the second insulating layer 26 may be bonded together by bonding the planar surface 22 on each first insulating layer 18 to another first insulating layer 18 and by bonding the planar surface 22 of one of the first insulating layers 18, e.g. an outer first insulating layer 18, to the second insulating layer 26. In other words, the planar surface 22 on each first insulating layer 18 is either bonded to another first insulating layer 18 or a second insulating layer 26, e.g. to form an electrode 16 with a stacked arrangement of electrode portions 16a.

It will be appreciated that the electrode 16 described herein is not limited to the arrangement shown in Figure 7. In other embodiments, the method may comprise a different number and/or order of the first and/or second insulating layers.

As described above, the electrode 16 may comprise vias 28. The vias 28 may be part of the first insulating layer 18 and/or the second insulating layer 26. The vias 28 may comprise an electrically conducting material, such as a conducting ceramic material. The conducting ceramic material may comprise doped silicon nitride. The dopant or dopant material may comprise titanium nitride. A volume concentration of the dopant or dopant material in silicon nitride may be between about 1% and 50%. A volume resistance of silicon nitride may depend on the volume concentration of the dopant or dopant material. For example, silicon nitride having a volume concentration of about 35% of titanium nitride may comprise a volume resistance of about 0.6 × 10⁻³ Ohm·cm. It will be appreciated that in other embodiments, the vias may comprise a conducting glass material.

The vias 28 may be formed by locally doping the first and/or second insulating layers 18, 26. The first and/or second insulating layers may be doped using a printing process. The vias 28 may be formed in the first and/or second insulating layers 18, 26 prior to the sintering and/or hot press process described above.

Although Figure 7 shows the vias 28 only in one of the first insulating layers 18 of the electrode 16, it will be appreciated that one or more vias may also be provided in any of the other first insulating layers and/or the second insulating layers.

The bonding steps of the method 100 described above may be performed in a single bonding step or as separate bonding steps.

It will be appreciated that any features described in relation to the method 100 may also apply to the electrode 16 described above.

The terms "planar surface" may be considered as encompassing the terms "substantially planar surface."

It will be understood that references to a plurality of features may be interchangeably used with references to singular forms of those features, such as for example "at least one" and/or "each". Singular forms of a feature, such as for example "at least one" or "each," may be used interchangeably.

Although embodiments of the invention have been described in connection with a substrate, a substrate holder and a substrate table, embodiments of the invention may be used to clamp a mask MA (or other patterning device) to a support structure MT of a lithographic apparatus (see Figure 1), or to clamp some other object.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions. An object holder according to an embodiment of the invention may form part of a lithographic tool.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

### Examples

1. A method of manufacturing an electrode for an object holder, the method comprising:
   forming at least two electrode portions on a first insulating layer, the at least two electrode portions being spaced from each other;
   forming at least one insulating portion on the first insulating layer between the at least two electrode portions such that the at least one insulating portion fills a space between the at least two electrode portions and the at least two electrode portions form a planar surface with the at least one insulating portion; and
   bonding a second insulating layer to the planar surface.
2. The method of example 1, wherein the at least two electrode portions and the at least one insulating portion have the same height.
3. The method of example 1 or 2, wherein the at least two electrode portions and the at least one insulating portion are formed on:
   at least one side of the first insulating layer, or
   each of at least two opposite sides of the first insulating layer, wherein when the at least two electrode portions and the at least one insulating portion are formed on each of the at least two opposite sides of the first insulating layer, the method comprises bonding a second insulating layer to the planar surface formed on each of the at least two opposite sides of the first insulating layer.
4. The method of any preceding example, wherein the method comprises:
   forming at least two electrode portions on each of a plurality of first insulating layers;
   forming at least one insulating portion on each of the plurality of the first insulating layers between the at least two electrode portions such that the at least one insulating portion fills a space between the at least two electrode portions and the at least two electrode portions form a planar surface with the at least one insulating portion; and
   bonding the plurality of first insulating layers and the second insulating layer together such that the at least two electrode portions and the at least insulating portion on each of the plurality of first insulating layer are arranged:
      between the second insulating layer and a respective first insulating layer of the plurality of first insulating layers, and/or
      between the respective first insulating layer of the plurality of first insulating layers and at least one other of the plurality of first insulating layers.
5. The method of example 4, wherein the at least two electrode portions and the at least one insulating portion are formed on:
   at least one side of at least one or each of the plurality of first insulating layers, and/or
   each of at least two opposite sides of at least one of the plurality of first insulating layers.
6. The method of example 4 or 5, wherein the method comprises bonding the second insulating layer to the planar surface and/or bonding the plurality of first insulating layers and/or the second insulating layer together using at least one of:
   a diffusion bonding process;
   an anodic bonding process;
      a Spark plasma assisted hot press process; and/or
   an optical contact bonding process.
7. The method of any one of examples 4 to 6, wherein forming the at least one insulating portion on the first insulating layer and/or each of the plurality of first insulating layers comprises:
   depositing a layer of insulating material on the at least two electrode portions and the first insulating layer and/or on each of the plurality of first insulating layers;
   removing a portion of the layer of insulating material such that the at least two electrode portions form the planar surface with at least one remaining portion of the layer of insulating material, the at least one remaining portion forming the at least one insulating portion.
8. The method of any one of examples 4 to 7, wherein the first insulating layer, the second insulating layer and/or at least one or each of the plurality of first insulating layers comprises a ceramic material or glass material, the ceramic material or glass material of at least one of: the first insulating layer, the at least one or each of the plurality of first insulating layers and/or the second insulating layer being the same as or different from the ceramic material or glass material of at least one other of: the first insulating layer, the at least one or each of the plurality of first insulating layers and/or the second insulating layer.
9. The method of any preceding example, wherein the at least two electrode portions comprise an electrically conductive material and the at least one insulating portion comprises an insulating material, a hardness of the insulating material being less than a hardness of the electrically conductive material.
10. The method of example 9, wherein the electrically conductive material comprises at least one of: a conductive ceramic material, a semiconductor material and/or doped diamond; and/or wherein the insulating material comprises at least one of: a quartz material, a glass material and/or a ceramic material.
11. The method of any one of examples 4 to 10, wherein the first insulating layer, at least one of the plurality of first insulating layers and/or the second insulating layer comprises one or more electrically conductive portions arranged to electrically connect:
   one or more respective electrode portions of the at least two electrode portions arranged or formed on each of the at least two opposite sides of the first insulating layer and/or the at least one of the plurality of first insulating layers with each other; and/or
   one or more electrode portions of the at least two electrodes portion formed or arranged on the first insulating layer and/or the at least one of the plurality of first insulating layers with another part or component of the object holder.

## Claims

1. A method of manufacturing an electrode for an object holder, the method comprising:
forming at least two electrode portions on a first insulating layer, the at least two electrode portions being spaced from each other;
forming at least one insulating portion on the first insulating layer between the at least two electrode portions such that the at least one insulating portion fills a space between the at least two electrode portions and the at least two electrode portions form a planar surface with the at least one insulating portion; and
bonding a second insulating layer to the planar surface.

2. The method of claim 1, wherein the at least two electrode portions and the at least one insulating portion have the same height.

3. The method of claim 1 or 2, wherein the at least two electrode portions and the at least one insulating portion are formed on:
at least one side of the first insulating layer, or
each of at least two opposite sides of the first insulating layer, wherein when the at least two electrode portions and the at least one insulating portion are formed on each of the at least two opposite sides of the first insulating layer, the method comprises bonding a second insulating layer to the planar surface formed on each of the at least two opposite sides of the first insulating layer.

4. The method of any preceding claim, wherein the method comprises:
forming at least two electrode portions on each of a plurality of first insulating layers;
forming at least one insulating portion on each of the plurality of the first insulating layers between the at least two electrode portions such that the at least one insulating portion fills a space between the at least two electrode portions and the at least two electrode portions form a planar surface with the at least one insulating portion; and
bonding the plurality of first insulating layers and the second insulating layer together such that the at least two electrode portions and the at least insulating portion on each of the plurality of first insulating layer are arranged:
between the second insulating layer and a respective first insulating layer of the plurality of first insulating layers, and/or
between the respective first insulating layer of the plurality of first insulating layers and at least one other of the plurality of first insulating layers.

5. The method of claim 4, wherein the at least two electrode portions and the at least one insulating portion are formed on:
at least one side of at least one or each of the plurality of first insulating layers, and/or
each of at least two opposite sides of at least one of the plurality of first insulating layers.

6. The method of claim 4 or 5, wherein the method comprises bonding the second insulating layer to the planar surface and/or bonding the plurality of first insulating layers and/or the second insulating layer together using at least one of:
a diffusion bonding process;
an anodic bonding process;
a Spark plasma assisted hot press process; and/or
an optical contact bonding process.

7. The method of any one of claims 4 to 6, wherein forming the at least one insulating portion on the first insulating layer and/or each of the plurality of first insulating layers comprises:
depositing a layer of insulating material on the at least two electrode portions and the first insulating layer and/or on each of the plurality of first insulating layers;
removing a portion of the layer of insulating material such that the at least two electrode portions form the planar surface with at least one remaining portion of the layer of insulating material, the at least one remaining portion forming the at least one insulating portion.

8. The method of any one of claims 4 to 7, wherein the first insulating layer, the second insulating layer and/or at least one or each of the plurality of first insulating layers comprises a ceramic material or glass material, the ceramic material or glass material of at least one of: the first insulating layer, the at least one or each of the plurality of first insulating layers and/or the second insulating layer being the same as or different from the ceramic material or glass material of at least one other of: the first insulating layer, the at least one or each of the plurality of first insulating layers and/or the second insulating layer.

9. An electrode for an object holder comprising:
at least two electrode portions arranged on a first insulating layer, the at least two electrode portions being spaced from each other;
at least one insulating portion arranged on the first insulating layer between the at least two electrode portions such that the at least one insulating portion fills a space between the at least two electrode portions and the at least two electrode portions form a planar surface with the at least one insulating portion; and
a second insulating layer bonded to the planar surface.

10. The electrode of claim 9, wherein the at least two electrode portions and the at least one insulating portion are arranged on at least one side of the first insulating layer or on each of at least two opposite sides of the first insulating layer, wherein when the at least two electrode portions and the at least one insulating portion are arranged on each of the at least two opposite sides of the first insulating later, a second insulating layer is bonded to the planar surface formed on each of the at least two opposite sides of the first insulating layer.

11. The electrode of claim 9 or 10, wherein electrode comprises:
a plurality of first insulating layers, the at least two electrode portions being arranged on each of the plurality of first insulating layers;
at least one insulating portion arranged on each of the plurality of the first insulating layers between the at least two electrode portions such that the at least one insulating portion fills a space between the at least two electrode portions and the at least two electrode portions form a planar surface with the at least one insulating portion; and
wherein the plurality of first insulating layers and the second insulating layer are bonded together such that the at least two electrode portions and the at least one insulating portion on each of the plurality of first insulating layers are arranged:
between the second insulating layer and a respective first insulating layer of the plurality of first insulating layers, and/or
between the respective first insulating layer of the plurality of first insulating layers and at least one other of the plurality of first insulating layers.

12. An object holder configured to support an object comprising an electrode according to any one of claims 9 to 11.

13. An object table comprising an object holder according to claim 12.

14. A lithographic apparatus comprising:
an illumination system;
a projection system; and
an object table according to claim 13.

15. A semiconductor processing tool comprising an object table according to claim 13.
